# EUROPEAN PATENT APPLICATION

(11) **EP 1 473 384 A1**
(43) Date of publication of application: **03.11.2004**
(21) Application number: 04009365.0
(22) Date of filing: 21.04.2004
(51) Int. Cl.: C23C 16/448, B01F 3/02

(54) **Vaporizer**

(30) Priority: 01.05.2003 JP 2003126119
(71) Applicant: JAPAN PIONICS CO., LTD., Minato-ku, Tokyo (JP)
(72) Inventor: Takamatsu, Yukichi, Hiratsuka-shi Kanagawa (JP); Asano, Akira, Hiratsuka-shi Kanagawa (JP); Iwata, Mitsuhiro, Hiratsuka-shi Kanagawa (JP); Tayama, Tatsunori, Hiratsuka-shi Kanagawa (JP)
(74) Representative: Leifert & Steffan

(57) **Abstract**

A vaporizer which comprises a vaporization chamber for a CVD material, a CVD material feed portion for supplying the vaporization chamber with the CVD material, a vaporized gas exhaust port and a heating means for heating the vaporization chamber, characterized in that it further comprises an ejection tube of double structure (9,10) wherein the outer diameter of the outer tube (10) has a portion (12) gradually thinning towards the ejection port to the vaporization chamber.

## Description

### BACKGROUND OF THE INVENTION

### Field of the Invention

The present invention relates to a vaporizer for supplying a chemical vapor deposition (CVD) apparatus used in the manufacture of a semiconductor with a gaseous CVD-material. More particularly, it pertains to a vaporizer employed for vaporizing and supplying a liquid CVD-material or a CVD-material made by dissolving a solid CVD-material in a solvent to the semiconductor manufacturing apparatus each at desirable concentration and flow rate in high efficiency without causing separating or adhesion in the vaporizer.

### Description of the Related Prior Art

Recently in the field of semi-conductors, a lead titanate zirconate (PZT) film, a barium strontium titanate (BST) film, a tantalic acid strontium bismuth (SBT) film, a titanic acid zirconate lantern lead (PLZT) film, etc., each having a high dielectric constant and also a high step coverage has been used as an oxide-based dielectric film for a semiconductor memory. In regard to the CVD material for the foregoing thin films, there are used Pb(DPM)₂ (solid material) as a Pb source; Zr(OC(CH₃)₃)₄ (liquid material) and Zr(DPM)₄ (solid material) as Zr sources; Ti(OCH(CH₃)₂)₄ (liquid material) and Ti(OCH(CH₃)₂)₂(DPM)₂ (solid material) as Ti sources; Ba(DPM)₂ (solid material) as a Ba source; and Sr(DPM)₂ (solid material) as a Sr source.

A liquid material, when being used as a CVD material, is usually introduced into a vaporizer along with a carrier gas, and the mixed gas is made into a gaseous form in the vaporizer and thereafter is fed to a CVD apparatus. However, it is difficult to vaporize a liquid material at a desirable concentration and flow rate in high efficiency without deteriorating the quality thereof, since the liquid material has usually a low vapor pressure, a high viscosity and a vaporizing temperature close to a decomposing temperature. A solid material, although being capable of assuring highly pure material by being kept at a high temperature to sublime itself, makes it extremely difficult to assure sufficient supply amount in an industrial scale. Thus, in general it is dissolved in a solvent such as tetrahydofuran to make it into a liquid material so as to vaporize. However, since a solid material has a vaporizing temperature greatly different from that of a solvent, a solvent alone is more apt to vaporize by heating, thereby making it more difficult to vaporize a liquid material.

Such being the case, highly advanced technique is required for manufacturing an insulated thin film by using a material in liquid or solid form. Conversely, an insulated thin film having high quality and high purity is expectable by the use of a liquid material or solid material. Accordingly, a variety of vaporizers and apparatuses for vaporizing and supplying have been developed for the purpose of efficiently vaporizing the aforesaid material without deteriorating the quality thereof.

As such a vaporizer, for example, a vaporizer which comprises a CVD material feed portion having a contact area with the CVD material wherein the contact area comprises a corrosion resistant synthetic resin such as fluoric resin, polyimide-based resin, and so on is generally known. Further, U. S. Patent No. 6,473,563 B2 discloses an apparatus for vaporizing and supplying which comprises a cooler and the vaporizer wherein the inside of the CVD material feed portion of the vaporizer and the surface on the side of the vaporization chamber of the CVD material feed portion are constituted of a corrosion resistant synthetic resin; the feed portion in contact with the outside of the vaporizer is constituted with a metal; and the CVD material feed portion which is constituted with a metal and which undergoes heat transfer from the heating means upon heating the vaporization chamber can be cooled with a cooler.

In the foregoing vaporizer, a material for composing a passageway of CVD material or a passageway for CVD material and carrier gas is proposed to be a corrosion resistant synthetic resin not only heat resistant but also with adiabatic property and having a characteristic whereon CVD material hardly adheres. Because it can prevent a sudden heating for the material even in a case with the use of the material prepared by dissolving solid CVD material into an organic solvent, only the solvent vaporizes and the CVD material hardly separates, resulting in high vaporizing efficiency of 99.9 % or more in the vaporizer. In addition, the foregoing apparatus for vaporizing and supplying is equipped with a mechanism for cooling the CVD material feed portion at the time of heating the vaporization chamber, and the apparatus was least liable to the adhesion of deposits.

However, although the foregoing vaporizer or the foregoing apparatus for vaporizing and supplying is effective in preventing separating and adhesion of the solid CVD material in a CVD material feed portion, decreasing the feed amount of carrier gas supplied by accompanying with the CVD material or increasing the concentration of solid CVD material dissolved in the solvent will strengthen the tendency of vaporizing only the solvent in the same manner as other vaporizers. As a result, there was an anxiety that stable vaporization and supply were impossible because the solid CVD material separated and adhered in the neighborhood of ejection port to the vaporization chamber for CVD material, thereby causing a pressure fluctuation of the vaporized gas or a concentration fluctuation of the CVD material. However, in the chemical vapor deposition, elevating the use efficiency as well as making a film formation of a semiconductor film of high quality and high purity easy both by feeding the CVD material with high concentration are preferable.

### SUMMARY OF THE INVENTION

In such circumstances, an object of the present invention is to provide, even in the case where decreasing the feed amount of carrier gas supplied by accompanying with the CVD material or increasing the concentration of solid CVD material dissolved in the solvent, a vaporizer capable of suppressing the separating and adhesion of the solid CVD material near the ejection port to the vaporization chamber and capable of vaporizing and supplying the CVD material with extreme high vaporizing efficiency and stably for long time, with a desired concentration and a desired flow amount.

The inventors of this invention zealously studied in order to overcome the above-described problems, and found that in a vaporizer comprising an ejection tube of double structure consisting of a passageway for the CVD material as an inner tube, and a passageway for the carrier gas as an outer tube in the CVD material feed portion, by employing an ejection tube of double structure wherein the outer diameter of the outer tube has a portion gradually thinning towards the ejection port to the vaporization chamber, even in the case where the feed amount of carrier gas or the amount of the solvent being decreased, a vaporizer capable of suppressing the separating and adhesion of the solid CVD material near the ejection port to the vaporization chamber and capable of vaporizing and supplying the CVD material with extreme high vaporizing efficiency and stably for long time, with a desired concentration and a desired flow amount become possible.

Namely, the present invention provides a vaporizer which comprises a vaporization chamber for a CVD material, a CVD material feed portion for supplying the vaporization chamber with the CVD material, a vaporized gas exhaust port and a heating means for heating the vaporization chamber, characterized in that it further comprises an ejection tube of double structure wherein the outer diameter of the outer tube has a portion gradually thinning towards the ejection port to the vaporization chamber.

### BRIEF DESCRIPTION OF THE DRAWINGS

FIG.1 is a vertical cross-sectional view showing an embodiment of a vaporizer of the present invention;
FIG. 2 is a vertical cross-sectional view showing another embodiment of a vaporizer of the present invention;
FIG. 3 is a vertical cross-sectional view showing still another embodiment of a vaporizer of the present invention;
FIG. 4 (1) to (4) each is a vertical cross-sectional view showing a constitutional example of a CVD material feed portion in the vaporizer of the present invention;
FIG. 5 (1) to (4) each is a vertical cross-sectional view showing a constitutional example of an ejection tube of double structure at an ejection port to a vaporization chamber in the vaporizer of the present invention;
Fig. 6 (a) to (e) each is a horizontal cross-sectional view taken on line a-a', line b-b', line c-c', line d-d', and line e-e' of FIG. 4 respectively; and
FIG. 7 is a block diagram showing one example of the apparatus for vaporizing and supplying to which is applied the vaporizer in accordance with the present invention.

### DESCRIPTION OF THE PREFERRED EMBODIMENTS

The present invention is applied to a vaporizer which vaporizes a liquid CVD-material or a liquid CVD-material made up of a solution of a liquid CVD-material or a solid CVD-material in a solvent, and which supplies CVD equipment or the like with a vaporized gas. However, in the case where a solid CVD-material is used, the vaporizer exhibits its effect particularly in view of the capability of preventing the separating and adhesion of a solid CVD material at a CVD material feed portion of the vaporizer.

The present invention provides a vaporizer which comprises a vaporization chamber for a CVD material, a CVD material feed portion for supplying the vaporization chamber with the CVD material, a vaporized gas exhaust port and a heating means for heating the vaporization chamber, characterized in that it further comprises an ejection tube of double structure wherein the outer diameter of the outer tube has a portion gradually thinning towards the ejection port to the vaporization chamber.

The CVD material to which are applicable the vaporizer is not specifically limited, provided that the CVD material can be kept in liquid state whether it is in liquid state at ordinary temperature or a solution of a solid dissolved in a solvent. The CVD material is properly and optionally selected for use according to the purpose of use. Examples thereof include an alkoxide in liquid state at ordinary temperature such as tetraisopropoxytitanium (Ti(OCH(CH₃)₂)₄), tetra-n-propoxytitanium (Ti(OC₃H₇)₄), tetra-tert-butoxyzirconium (Zr(OC(CH₃)₃)₄), tetra-n-butoxyzirconium (Zr(OC₄H₉)₄), tetramethoxyvanadium (V(OCH₃)₄), trimethoxyvanadyl oxide (VO(OCH₃)₃), pentaethoxyniobium (Nb(OC₂H₅)₅), pentaethoxytantalum (Ta(OC₂H₅)₅), trimethoxyboron (B(OCH₃)₃), triisopropoxyaluminum (Al(OCH(CH₃)₂)₃), tetraethoxysilicon (Si(OC₂H₅)₄), tetraethoxygermanium (Ge(OC₂H₅)₄), tetraethoxytin (Sn(OCH₃)₄), trimethoxyphosphorus (P(OCH₃)₃), trimethoxyphosphineoxide (PO(OCH₃)₃), triethoxyarsenic (As(OC₂H₅)₃) and triethoxyantimony (Sb(OC₂H₅)₃).

Examples of the CVD material in liquid state at ordinary temperature other than the foregoing include trimethylaluminum (Al(CH₃)₃), dimethylaluminum hydride (Al(CH₃)₂)H), triisobutylaluminum (Al(iso-C₄H₉)₃), hexafluoroacetylacetonecopper vinyltrimethylsilane ((CF₃CO)₂CHCu · CH₂CHSi(CH₃)₃), hexafluoroacetylacetonecopper allyltrimethylsilane ((CF₃CO)₂CHCu · CH₂CHCH₂Si(CH₃)₃), bis(isopropylcyclopentadienyl)tungsten dihydride ((iso-C₃H₇C₅H₅)₂WH₂), tetradimethylaminozirconium(Zr(N(CH₃)₂)₄), pentadimethylaminotantulum (Ta(N(CH₃)₂)₅), pentadiethylaminotantulum (Ta(N(C₂H₅)₂)₅), tetradimethylaminotitanium (Ti(N(CH₃)₂)₄) and tetradiethylaminotitanium (Ti(N(C₂H₅)₂)₄).

Further examples of the CVD material in solid state at ordinary temperature other than the foregoing include hexacarbonylmolybdenum (Mo(CO)₆), dimethylpenthoxygold (Au(CH₃)₂(OC₅H₇)), bismuth (III) tertiallybuthoxyd (Bi(OtBu)₃), bismuth (III) tertiallypenthoxyd (Bi(OtAm)₃), triphenylbismuth (BiPh₃), bis(ethylcyclopentadienyl)ruthenium(Ru(EtCp)₂), (ethylcyclopentadienyl) (trimethyl) platinum (Pt(EtCp)Me₃), 1,5-cyclooctadiene (ethylcyclopentadienyl) iridium (Ir(EtCp)(cod)), bis(hexaethoxytantalum) strontium (St[Ta(OEt)₆]₂), bis(hexaisopropoxytantalum) strontium (St[Ta(OiPr) ₆]₂),), tris(2,2,6,6,-tetramethyl-3,5 heptanedionite) lanthanum (La(DPM)₃), tris(2,2,6,6,-tetramethyl-3,5 heptanedionite) yttrium (Y(DPM)₃), tris(2,2,6,6,-tetramethyl-3,5 heptanedionite) ruthenium (Ru(DPM)₃), bis(2,2,6,6-tetramethyl3,5-heptanedionite)barium (Ba((C(CH₃)₃)₂C₃HO₂)₂), bis(2,2,6,6-tetramethyl-3,5-heptanedionite)strontium (Sr((C(CH₃)3)₂C₃HO₂)₂), tetra(2,2,6,6-tetramethyl-3,5-heptanedionite)titanium (Ti((C(CH₃)₃)₂C₃HO₂)₄), tetra(2,2,6,6-tetramethyl-3,5-heptanedionite)zirconium (Zr((C(CH₃)₃)₂C₃HO₂)₄), tetra(2,6,-dimethyl-3,5 heptanedionite) zirconium (Zr(DMHD)₄), bis(2,2,6,6-tetramethyl-3,5-heptanedionite)lead (Pb((C(CH₃)₃)₂C₃HO₂)₂), (ditertiallybuthoxybis)(2,2,6,6-tetramethyl-3,5-heptanedionite)tita nium (Ti(OtBu)₂(DPM)₂), (diisopropoxy)(2,2,6,6-tetramethyl-3,5-heptanedionite)titanium (Ti(OiPr)₂(DPM)₂), tetrakis(isobutyllylpivaloylmethanato)zirconium (Zr(OiPr)(DPM)₃), (di-isopropoxy) tris(2,2,6,6,-tetramethyl-3,5,-heptanedionite) tantalum (Ta(OiPr)₂(DPM)₃) and so on. The above-exemplified materials usually need to be dissolved in an organic solvent in a concentration of about 0.1 to about 1.0 mol/liter.

The above-mentioned organic solvent to be used as a solvent for a solid CVD-material is that having a boiling point temperature usually ranging from 40°C to 140°C. Examples of the solvent include such ethers as propyl ether, methylbutyl ether, ethylpropyl ether, ethylbutyl ether, trimethylene oxide, tetrahydrofuran and tetrahydropyran; alcohols such as methyl alcohol, ethyl alcohol, propyl alcohol and butyl alcohol; ketones such as acetone, ethyl methyl ketone, isopropyl methyl ketone and isobutyl methyl ketone; amines such as propylamine, butylamine, diethylamine, dipropylamine and triethylamine; esters such as ethyl acetate, propyl acetate and butyl acetate; and hydrocarbons such as hexane, heptane and octane.

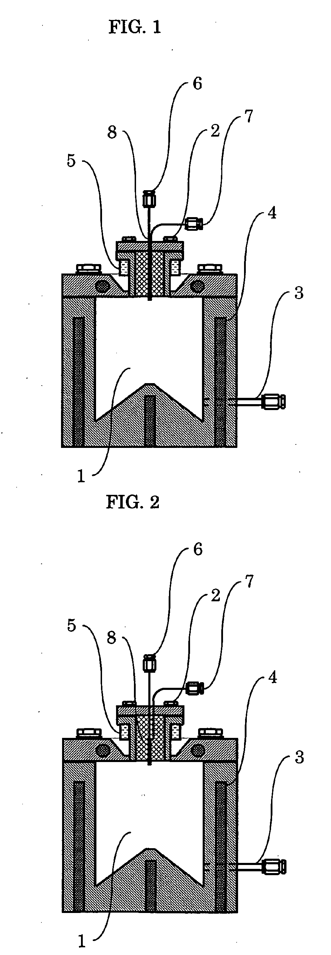

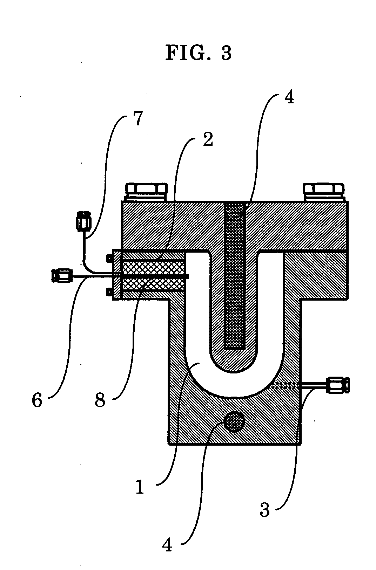

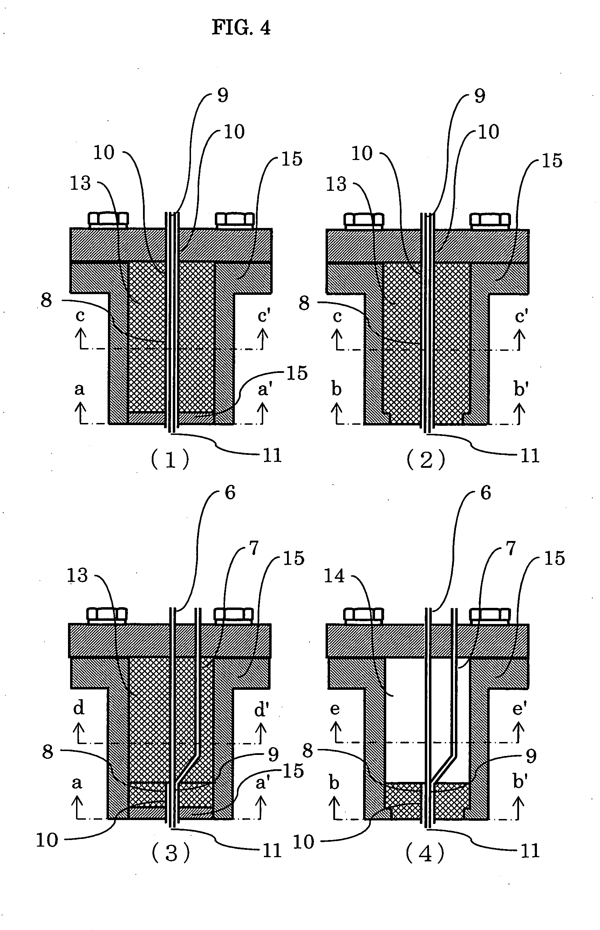

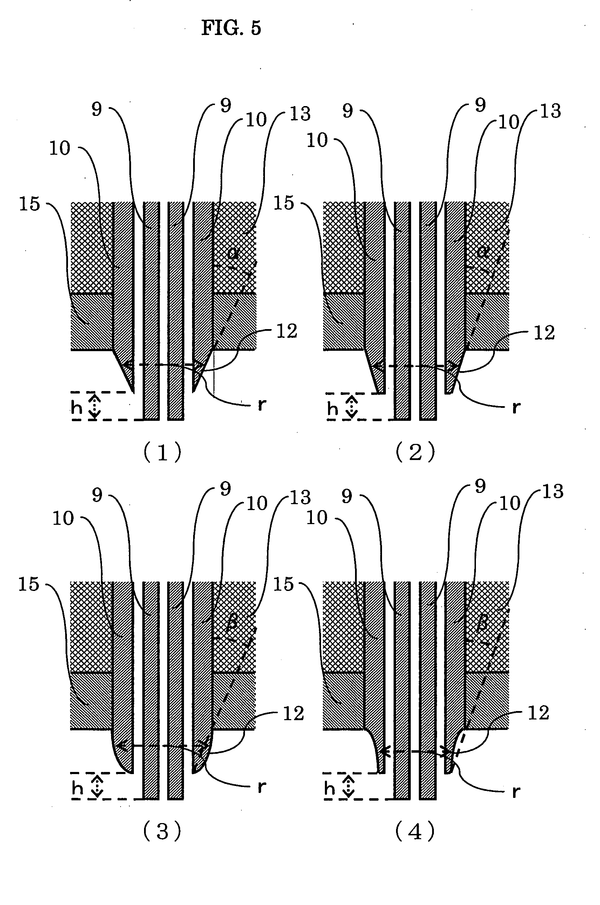

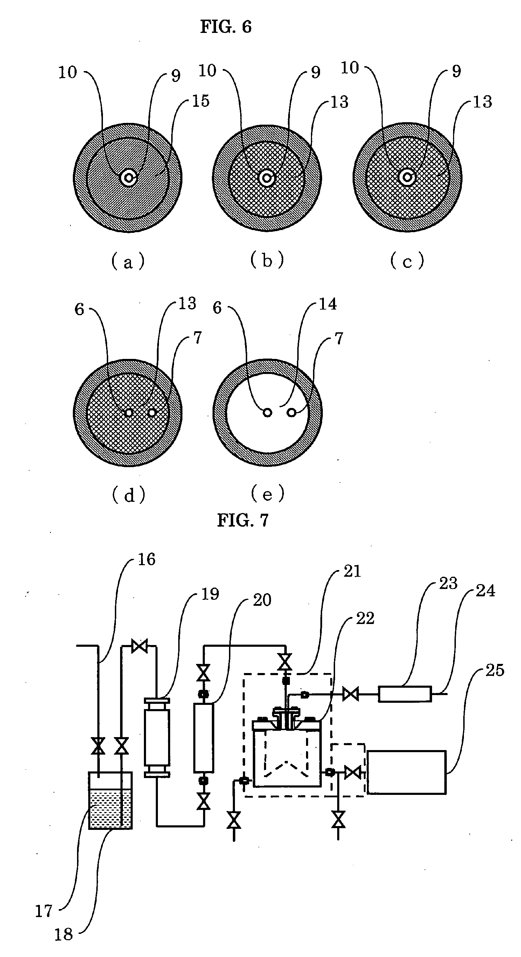

The vaporizer of the present invention will be described in further detail with reference to FIGS. 1 to 7, which does not limit the scope of the invention. FIGS. 1 to 3 each is a vertical cross-sectional view showing an embodiment of a vaporizer of the present invention respectively; FIG. 4 (1) to (4) each is a vertical cross-sectional view showing a constitutional example of a CVD material feed portion in the vaporizer as shown in FIGS. 1 and 2 of the present invention; FIG. 5 (1) to (4) each is a vertical cross-sectional view showing a constitutional example of an ejection tube of double structure at an ejection port to the vaporization chamber in the vaporizer of the present invention; Fig. 6 (a) to (e) each is a horizontal cross-sectional view taken on line a-a', line b-b', line c-c', line d-d', and line e-e' of FIG. 4 respectively; and FIG. 7 is a block diagram showing one example of the apparatus for vaporizing and supplying to which is applied the vaporizer in accordance with the present invention.

As illustrated in FIGS. 1 to 3, the vaporizer according to the present invention comprises a vaporization chamber 1 for a CVD material, a CVD material feed portion 2 for supplying the vaporization chamber with the CVD material, a vaporized gas exhaust port 3 and a heating means 4 (heater or the like) for heating the vaporization chamber. Further, it is desirable for the vaporizer of the present invention to be equipped with a cooling means 5 for the CVD material feed portion. Examples of such a cooling means include a pipe that provides cooling water along the upper surface or the side surface of the CVD material feed portion, etc.

In the vaporizer according to the present invention, the structure of the CVD material feed portion is not specifically restricted as far as it comprises the ejection tube of double structure consisting of an inner tube and an outer tube, thereby being capable of ejecting the CVD material and a carrier gas to the vaporization chamber. However, as shown in FIG. 4, embodiments of comprising both the ejection tube of double structure and the contact area with external portion constituted of a metal are practical. In the present invention, CVD material feed pipe 6 from outside of the vaporizer is usually connected to an inner tube 9 of ejection tube 8 of double structure. At the same time, carrier gas feed pipe 7 from outside of the vaporizer is connected to an outer passageway of ejection tube 8 of double structure (a passageway between inner tube 9 and outer tube 10), thereby ejecting the CVD material and the carrier gas from the inner passageway and the outer passageway of ejection tube 8 of double structure respectively to vaporization chamber 1.

Further, ejection tube 8 of double structure may be provided with penetrating the CVD material feed portion as shown in FIG. 4 (1) and (2) or may be provided only in the neighborhood of the ejection port of the vaporization chamber as shown in FIG. 4 (3) and (4). In the following, the ejection tube of double structure of the CVD material feed portion in the present invention will be explained in detail referring FIG. 5 showing a constitutional example of an ejection tube of double structure at ejection port 11 to the vaporization chamber.

The ejection tube of double structure in the vaporizer of the present invention has, as shown in FIG. 5, a portion wherein the outer diameter (r) of external wall 12 of the outer tube 10 gradually thinning towards the ejection port to the vaporization chamber in the neighborhood of the ejection port. Regarding external wall 12 of the outer tube 10, an angle (α) of a line through both starting end and finishing end of the gradually thinning portion to the central axis of the ejection tube (vertical direction in FIG. 5) is usually settled as 10 to 60 degrees, and preferably settled as 15 to 45 degrees. The line through both starting end and finishing end of the gradually thinning portion may be convex to the outside of the ejection tube in a vertical cross sectional view as in FIG. 5 (3) or may be concave to the inside of the ejection tube in a vertical cross sectional view as shown in FIG. 5 (4) respectively. In each cases, an angle (β) of a straight line through both starting end and finishing end of the gradually thinning portion to the central axis of the ejection tube (vertical direction) is usually settled as 10 to 60 degrees, and preferably settled as 15 to 45 degrees. When the angle is smaller than 10 degrees or when the angle exceeds 60 degrees, an anxiety reveals that the capability of preventing the separating and adhesion of a solid CVD material in the neighborhood of the ejection port of the vaporizer would degrade.

In the vaporizer of the present invention, ejection ports of both the inner tube and the outer tube of the ejection tube of double structure to the vaporization chamber usually have, as shown in FIG. 5, a structure protruding towards the vaporization chamber. Further, the ejection port to the vaporization chamber of inner tube 9 of the ejection tube of double structure preferably protrude to the vaporization chamber side from the ejection port to the vaporization chamber of outer tube 10. Such a structure would tremendously improve the capability of preventing the separating and adhesion of a solid CVD material in the neighborhood of the ejection port to the vaporization chamber. In this occasion, the length "h" of the protrusion in FIG. 5 is normally 2.0 mm or shorter, and is preferably 0.2 to 1.0 mm.

In the vaporizer of the present invention, although the shape of the walls such as the internal wall of the inner tube, the external wall of the inner tube and the internal wall of the outer tube other than the external wall of the outer tube composing the ejection tube of double structure is not specifically limited, any extraordinal shape shall preferably be evaded because it may unintentionally promote the separating and adhesion of the solid CVD material. Further, although the material for the ejection tube of double structure is not particularly specified, metals such as carbon steel, manganese steel, chrome steel, molybdenum steel, stainless steel, nickel steel and so on may be preferably employable.

In the vaporizer of the present invention, the inside of the CVD material feed portion is preferably hollow or composed of synthesized resin such as fluoric resin or polyimide-based resin and whose contact area with outside of the vaporizer is constituted of a metal. In the case where the inside of the CVD material feed portion is composed of synthesized resin, synthesized resin 13 is disposed as illustrated in FIG. 4 (1) to (3). In the case where the inside of the CVD material feed portion is a cavity, cavity 14 is formed as illustrated in FIG. 4 (4). By the application of the foregoing structure of the CVD material feed portion, even in the case of employing a solid CVD material dissolved in an organic solvent as the CVD material, any vaporization of only the solvent in the ejection tube induced by an abrupt elevation of the temperature caused by such a heating device as a heater can be prevented. On the other hand, because the CVD material must be suddenly heated just before the vaporization chamber, the contact area of the CVD material feed portion with the vaporization chamber is preferably constituted of metallic parts 15 (metal such as carbon steel, manganese steel, chrome steel, molybdenum steel, stainless steel, nickel steel, etc.) as illustrated in FIG. 4 (1) (3) along with the ejection tube of double structure.

Moreover, in the vaporizer of the present invention, the heating means for settling the desired temperature depending on the kind or the feeding amount of the liquid material, the concentration of the vaporized gas, or the other operating condition, and so on may be provided. The configuration of installing the heating means is not specifically limited unless it disturbs the capability of heating and thermally keeping the temperature of the vaporization chamber in favorable precision. For instance, a heater as a heating means is incorporated in a constitutional portion on the side of the vaporizer. However, for the purpose of further enhancing the effect on preventing quick heating of CVD material in the CVD material feed portion in the case of using a solid CVD-material dissolved in an organic solvent, it is preferable to install a cooling means such as supplying cold water in the outer wall of a vaporization chamber around the upper face or the side face of the CVD material feed portion so as to restrict the heat transmission to the feed portion.

Additionally, although one CVD material feed portion is disposed for one vaporizer, and one ejection tube of double structure is disposed for one CVD material feed portion in FIGS. 1 to 3, the embodiment of the present invention is not limited to these, and plural of CVD material feed portion for one vaporizer or plural of ejection tube of double structure for one CVD material feed portion may be adopted.

As shown in FIG. 7, vaporizer 22 of the present invention is used by connecting with CVD material container 18 containing liquid CVD material 17, degasser 19, liquid mass flow controller 20, and semiconductor manufacturing apparatus 25 and so on. Additionally, numerical symbol 16 shows an inert gas supply line, numerical symbol 21 shows a heat insulating material, numerical 23 shows a gas mass flow controller, and numerical symbol 24 shows a carrier gas supply line respectively in FIG. 7. The present invention is applicable for vaporizing and supplying to the film formation of ferroelectric substance film of such as PZT, BST, SBT, or PLZT, with the use of plural of vaporizer, with the use of plural of ejection tube of double structure inside of one CVD material feed portion, or with the use of plural of CVD material feed portion to one vaporizer.

### EXAMPLES

In the following examples are described several preferred embodiments to concretely illustrate the invention, however, it is to be understood that the invention is not intended to be limited to the specific embodiments.

### Example 1

There was prepared a CVD material feed portion having the passageways as illustrated in FIG. 4 (1) in which the inside thereof was constituted of a fluororesin (PFA), and the portion in contact with the outside of the vaporizer was constituted of stainless steel (SUS316). The PFA made portion was a column having an outside diameter of 16 mm and a height of 34.2 mm. The stainless steel outside the column had a thickness of 2.0 mm. Both the inner tube and the outer tube of the ejection tube of double structure were made of stainless steel (SUS 316), and the ejection port to the vaporization chamber had a structure as shown in FIG. 5 (1). The internal diameter and the external diameter of the inner tube of the ejection tube of double structure was 0.1 mm and 0.45 mm respectively, and the internal diameter of the outer tube was 0.6 mm. The angle (α) of a line through both starting end and finishing end of the gradually thinning portion to the central axis of the ejection tube was 30 degrees. Further, the ejection port of the outer tube protruded 8 mm to the vaporization chamber and the ejection port of the inner tube protruded 8.5 mm to the vaporization chamber. Additionally, a cooling pipe that flew cooling water along the top of the CVD material feed portion was equipped as a cooling means for the CVD material feed portion.

There was also prepared, in addition to the foregoing CVD material feed portion, as illustrated in FIG. 1, a vaporizer which was made of stainless steel (SUS316) and incorporated with a vaporized gas exhaust port, a heating means for the vaporization chamber and a protrusion housing a heater. The vaporization chamber was in the form of a column having an inside diameter of 65 mm and a height of 92.5 mm and a protrusion height at the bottom of 27.5 mm. The vaporized gas exhaust port was placed at a height of 15 mm from the bottom of the vaporizer. Subsequently, a vaporizing and supplying system as illustrated in FIG. 7 was fabricated by connecting a degasser, a liquid mass flow controller; a carrier gas feed line and the like.

A test for vaporizing and supplying was made in the following manner by the use of the foregoing equipment. The vaporization chamber was set on 1.3 kPa (10 torr) and at the temperature of 270 °C, the CVD material feed portion of the vaporizer was charged with a liquid CVD-material having a concentration of 0.3 mol/liter in which Zr(DPM)₄ as a solid CVD-material was dissolved in THF as a solvent at a flow rate of 0.2 g/min and argon gas at a flow rate of 200 milliliter/minute, and then the liquid CVD material was vaporized in the chamber. During the foregoing process, cooling water was supplied to maintain the temperature of the stainless steel of the CVD material feed portion at 30 ± 2 °C.

After continuous test for vaporizing and supplying for 5 hours, investigation was made on the state of adhesion of the solid CVD-material in the passageway of the CVD material feed portion and in the vaporization chamber. As a result, no separating or adhesion of the solid CVD-material was recognized by the human observation. Accordingly, tetrahydrofran (THF) was fed from the inner passageway of the ejection tube and after washing away and recovering the solid CVD material adhered in the passageway of the CVD material feed portion and in the vaporization chamber, the amount of the adhesion of the solid CVD material obtained by the evaporation of THF was weighed. The results are shown in Table 1.

### Example 2

Example 2 was conducted by the use of the system for vaporizing and supplying approximately the same as employed in Example 1 and a liquid CVD-material having a concentration of 0.3 mol/liter in which Pb(DPM)₂ as a solid CVD-material was dissolved in THF as a solvent was vaporized and supplied in the following manner. The vaporization chamber was set on 1.3 kPa (10 torr) and at the temperature of 210 °C, and by feeding the CVD material into the inner passageway of the ejection tube at a flow rate of 0.36 g/min and feeding argon gas into the outer passageway of the ejection tube at a flow rate of 200 milliliter/minute, the liquid CVD material was vaporized in the chamber. During the foregoing process, cooling water was supplied to maintain the temperature of the stainless steel of the CVD material feed portion at 30 ± 2 °C. After continuous test for vaporizing and supplying for 5 hours, and recovering the solid CVD material adhered in the passageway of the CVD material feed portion and in the vaporization chamber in the same manner as Example 1, the amount of the adhesion of the solid CVD material was weighed. The results are shown in Table 1.

### Example 3

Example 3 was conducted by the use of the system for vaporizing and supplying approximately the same as employed in Example 1 and a liquid CVD-material having a concentration of 0.3 mol/liter in which Ti(OiPr)₂(DPM)₂ as a solid CVD-material was dissolved in THF as a solvent was vaporized and supplied in the following manner. The vaporization chamber was set on 1.3 kPa (10 torr) and at the temperature of 210 °C, and by feeding the CVD material into the inner passageway of the ejection tube at a flow rate of 0.2 g/min and feeding argon gas into the outer passageway of the ejection tube at a flow rate of 200 milliliter/minute, the liquid CVD material was vaporized in the chamber. During the foregoing process, cooling water was supplied to maintain the temperature of the stainless steel of the CVD material feed portion at 30 ± 2 °C. After continuous test for vaporizing and supplying for 5 hours, and recovering the solid CVD material adhered in the passageway of the CVD material feed portion and in the vaporization chamber in the same manner as Example 1, the amount of the adhesion of the solid CVD material was weighed. The results are shown in Table 1.

### Example 4

The CVD material feed portion as illustrated in FIG. 4 (1) was prepared in a similar manner as Example 1 except that the angle (α) of the line through both starting end and finishing end of the gradually thinning portion to the central axis of the ejection tube was 15 degrees in Example 4. The same vaporizer as in Example 1 except the use of the foregoing CVD material feed portion was prepared, and a system for vaporizing and supplying was fabricated by connecting the degasser, the liquid mass flow controller, the carrier gas feed line and the like as employed in Example 1.

Example 4 was conducted by the use of the above system for vaporizing and supplying and a liquid CVD-material having a concentration of 0.3 mol/liter in which Zr(DPM)₄ as a solid CVD-material was dissolved in THF as a solvent was vaporized and supplied in the same manner as Example 1. After continuous test for vaporizing and supplying for 5 hours, and recovering the solid CVD material adhered in the passageway of the CVD material feed portion and in the vaporization chamber in the same manner as Example 1, the amount of the adhesion of the solid CVD material was weighed. The results are shown in Table 1.

### Example 5

The CVD material feed portion as illustrated in FIG. 4 (1) was prepared in a similar manner as Example 1 except that the angle (α) of the line through both starting end and finishing end of the gradually thinning portion to the central axis of the ejection tube was 45 degrees in Example 5. The same vaporizer as in Example 1 except the use of the above CVD material feed portion was prepared, and a system for vaporizing and supplying was fabricated by connecting the degasser, the liquid mass flow controller, the carrier gas feed line and the like as employed in Example 1.

Example 5 was conducted by the use of the above system for vaporizing and supplying and a liquid CVD-material having a concentration of 0.3 mol/liter in which Zr(DPM)₄ as a solid CVD-material was dissolved in THF as a solvent was vaporized and supplied in the same manner as Example 1. After continuous test for vaporizing and supplying for 5 hours, and recovering the solid CVD material adhered in the passageway of the CVD material feed portion and in the vaporization chamber in the same manner as Example 1, the amount of the adhesion of the solid CVD material was weighed. The results are shown in Table 1.

### Example 6

The CVD material feed portion was prepared in a similar manner as Example 1 except that the ejection tube at the ejection port to the vaporization chamber had a structure as illustrated in FIG. 5 (2) in Example 6, wherein the cross sectional view of the leading end of the outer tube was inverted trapezoidal having a bottom side of 0.25 mm, and the angle (α) was 30 degrees. The same vaporizer as in Example 1 except the use of the above CVD material feed portion was prepared, and a system for vaporizing and supplying was fabricated by connecting the degasser, the liquid mass flow controller, the carrier gas feed line and the like as employed in Example 1.

Example 6 was conducted by the use of the above system for vaporizing and supplying and a liquid CVD-material having a concentration of 0.3 mol/liter in which Zr(DPM)₄ as a solid CVD-material was dissolved in THF as a solvent was vaporized and supplied in the same manner as Example 1. After continuous test for vaporizing and supplying for 5 hours, and recovering the solid CVD material adhered in the passageway of the CVD material feed portion and in the vaporization chamber in the same manner as Example 1, the amount of the adhesion of the solid CVD material was weighed. The results are shown in Table 1.

### Example 7

The CVD material feed portion was prepared in a similar manner as Example 1 except that the ejection tube at the ejection port to the vaporization chamber had a structure as illustrated in FIG. 5 (3) in Example 7, wherein the cross sectional view of the leading end of the outer tube was a half ellipse, and the angle (β) was 30 degrees. The same vaporizer as in Example 1 except the use of the above CVD material feed portion was prepared, and a system for vaporizing and supplying was fabricated by connecting the degasser, the liquid mass flow controller, the carrier gas feed line and the like as employed in Example 1.

Example 7 was conducted by the use of the above system for vaporizing and supplying and a liquid CVD-material having a concentration of 0.3 mol/liter in which Zr(DPM)₄ as a solid CVD-material was dissolved in THF as a solvent was vaporized and supplied in the same manner as Example 1. After continuous test for vaporizing and supplying for 5 hours, and recovering the solid CVD material adhered in the passageway of the CVD material feed portion and in the vaporization chamber in the same manner as Example 1, the amount of the adhesion of the solid CVD material was weighed. The results are shown in Table 1.

### Example 8

Example 8 was conducted in a similar manner as Example 1 except that the feed rate of the argon gas to the vaporizer was reduced to 100 milliliter/minute and the liquid CVD-material having the concentration of 0.3 mol/liter in which Zr(DPM)₄ as the solid CVD-material was dissolved in THF as a solvent was vaporized and supplied. After continuous test for vaporizing and supplying for 5 hours, and recovering the solid CVD material adhered in the passageway of the CVD material feed portion and in the vaporization chamber in the same manner as Example 1, the amount of the adhesion of the solid CVD material was weighed. The results are shown in Table 1.

### Example 9

Example 9 was conducted in a similar manner as Example 2 except that the feed rate of the argon gas to the vaporizer was reduced to 100 milliliter/minute and the liquid CVD-material having the concentration of 0.3 mol/liter in which Pb(DPM)₂ as the solid CVD-material was dissolved in THF as a solvent was vaporized and supplied. After continuous test for vaporizing and supplying for 5 hours, and recovering the solid CVD material adhered in the passageway of the CVD material feed portion and in the vaporization chamber in the same manner as Example 1, the amount of the adhesion of the solid CVD material was weighed. The results are shown in Table 1.

### Example 10

Example 10 was conducted in a similar manner as Example 3 except that the feed rate of the argon gas to the vaporizer was reduced to 100 milliliter/minute and the liquid CVD-material having the concentration of 0.3 mol/liter in which Ti(OiPr)₂(DPM)₂ as the solid CVD-material was dissolved in THF as a solvent was vaporized and supplied. After continuous test for vaporizing and supplying for 5 hours, and recovering the solid CVD material adhered in the passageway of the CVD material feed portion and in the vaporization chamber in the same manner as Example 1, the amount of the adhesion of the solid CVD material was weighed. The results are shown in Table 1.

### Comparative Example 1

The CVD material feed portion was prepared in a similar manner as Example 1 except that the outer diameter of the outer tube of the ejection tube of double structure was straight (the angle (α) equals zero) without having a portion gradually thinning towards the ejection port to the vaporization chamber. The same vaporizer as in Example 1 except the use of the foregoing CVD material feed portion was prepared, and a system for vaporizing and supplying was fabricated by connecting a degasser, a liquid mass flow controller, a carrier gas feed line and the like as employed in Example 1.

Comparative Example 1 was conducted by the use of the above system for vaporizing and supplying and a liquid CVD-material having a concentration of 0.3 mol/liter in which Zr(DPM)₄ as a solid CVD-material was dissolved in THF as a solvent was vaporized and supplied in the same manner as Example 1. After continuous test for vaporizing and supplying for 5 hours, and recovering the solid CVD material adhered in the passageway of the CVD material feed portion and in the vaporization chamber in the same manner as Example 1, the amount of the adhesion of the solid CVD material was weighed. The results are shown in Table 1.

### Comparative Example 2

The system for vaporizing and supplying was fabricated by the use of the same vaporizer as in Comparative Example 1. Comparative Example 2 was conducted in the same manner as Example 2 except the employment of the above system and a liquid CVD-material having a concentration of 0.3 mol/liter in which Pb(DPM)₂ as a solid CVD-material was dissolved in THF as a solvent was vaporized and supplied. After continuous test for vaporizing and supplying for 5 hours, and recovering the solid CVD material adhered in the passageway of the CVD material feed portion and in the vaporization chamber in the same manner as Example 1, the amount of the adhesion of the solid CVD material was weighed. The results are shown in Table 1.

### Comparative Example 3

The system for vaporizing and supplying was fabricated by the use of the same vaporizer as in Comparative Example 1. Comparative Example 3 was conducted in the same manner as Example 3 except the employment of the above system and a liquid CVD-material having a concentration of 0.3 mol/liter in which Ti(OiPr)₂(DPM)₂ as a solid CVD-material was dissolved in THF as a solvent was vaporized and supplied. After continuous test for vaporizing and supplying for 5 hours, and recovering the solid CVD material adhered in the passageway of the CVD material feed portion and in the vaporization chamber in the same manner as Example 1, the amount of the adhesion of the solid CVD material was weighed. The results are shown in Table 1.

### Comparative Example 4

Comparative Example 4 was conducted in a similar manner as Comparative Example 1 except that the feed rate of the argon gas to the vaporizer was reduced to 100 milliliter/minute similarly as Example 8 and the liquid CVD-material having the concentration of 0.3 mol/liter in which Zr(DPM)₄ as the solid CVD-material was dissolved in THF as a solvent was vaporized and supplied. After continuous test for vaporizing and supplying for 5 hours, and recovering the solid CVD material adhered in the passageway of the CVD material feed portion and in the vaporization chamber in the same manner as Example 1, the amount of the adhesion of the solid CVD material was weighed. The results are shown in Table 1.

**Table 1**

| | CVD material* | Structure of ejection tube | Angle α,β (degrees) | Feed rate of Ar gas (ml/min) | Adhered CVD material (mg) |
|---|---|---|---|---|---|
| Example 1 | Zr | FIG. 5 (1) | 30 | 200 | less than 1 |
| Example 2 | Pb | FIG. 5 (1) | 30 | 200 | 4 |
| Example 3 | Ti | FIG. 5 (1) | 30 | 200 | 2 |
| Example 4 | Zr | FIG. 5 (1) | 15 | 200 | 15 |
| Example 5 | Zr | FIG. 5 (1) | 45 | 200 | 2 |
| Example 6 | Zr | FIG. 5 (2) | 30 | 200 | 1 |
| Example 7 | Zr | FIG. 5 (3) | 30 | 200 | 5 |
| Example 8 | Zr | FIG. 5 (1) | 30 | 100 | 3 |
| Example 9 | Pb | FIG. 5 (1) | 30 | 100 | 8 |
| Example 10 | Ti | FIG. 5 (1) | 30 | 100 | 6 |
| Comp. Ex. 1 | Zr | - | - | 200 | 83 |
| Comp. Ex. 2 | Pb | - | - | 200 | 176 |
| Comp. Ex. 3 | Ti | - | - | 200 | 102 |
| Comp. Ex. 4 | Zr | - | - | 100 | 450 |

| | | | | | |
|---|---|---|---|---|---|
| * Zr stands for Zr(DPM)₄, Pb stands for Pb(DPM)₂, and Ti stands for Ti(OiPr)₂(DPM)₂. | | | | | |

The vaporizer in accordance with the present invention provide, even in the case where decreasing the feed amount of carrier gas supplied by accompanying with the CVD material or increasing the concentration of solid CVD material dissolved in the solvent, a capability of suppressing the separating and adhesion of the solid CVD material near the ejection port to the vaporization chamber. Accordingly, a pressure fluctuation of the vaporized gas or a concentration fluctuation of the CVD material was suppressed and the vaporizing and supplying the CVD material with extreme high vaporizing efficiency and stably for long time, with a desired concentration and a desired flow amount became possible. As a result, use efficiency of the CVD material increased, and the film forming of the semiconductor film with high quality and high purity became easy.

Having described the invention in detail, those skilled in the art will appreciate that, given the present disclosure; modifications may be made to the invention without departing from the spirit of the inventive concept described therein. Therefore, it is not intended that the scope of the invention be limited to the specific and preferred embodiments illustrated and described. Rather, it is intended that the scope of the invention be determined by the appended claims.

## Claims

1. A vaporizer which comprises a vaporization chamber for a CVD material, a CVD material feed portion for supplying the vaporization chamber with the CVD material, a vaporized gas exhaust port and a heating means for heating the vaporization chamber, **characterized in that** it further comprises an ejection tube of double structure wherein the outer diameter of the outer tube has a portion gradually thinning towards the ejection port to the vaporization chamber.

2. The vaporizer according to Claim 1, wherein an angle of a straight line through both starting end and finishing end of said gradually thinning portion to a vertical line is 0 to 60 degrees.

3. The vaporizer according to Claim 1, wherein a curved line through both starting end and finishing end of said gradually thinning portion is convex to the outside in a vertical cross sectional view.

4. The vaporizer according to Claim 1, wherein a curved line through both starting end and finishing end of said gradually thinning portion is concave to the inside in a vertical cross sectional view.

5. The vaporizer according to Claim 1, wherein an inner tube of said ejection tube has a function of ejecting said CVD material to said vaporization chamber, and wherein said outer tube has a function of ejecting a carrier gas to said vaporization chamber.

6. The vaporizer according to Claim 1, wherein ejection ports of both said inner tube and said outer tube to said vaporization chamber have a structure protruding towards said vaporization chamber.

7. The vaporizer according to Claim 1, wherein the ejection port of said inner tube to said vaporization chamber has a structure protruding towards said vaporization chamber farther than the ejection port of said outer tube to said vaporization chamber.

8. The vaporizer according to Claim 1, wherein the inside of said CVD material feed portion is composed of synthesized resin and whose contact area with outside of said vaporizer is constituted of a metal.

9. The vaporizer according to Claim 1, wherein the inside of said CVD material feed portion is hollow and whose contact area with an external portion of said vaporizer is constituted of a metal.

10. The vaporizer according to Claim 1, wherein a contact area of said CVD material feed portion with said vaporization chamber is constituted of a metal.

11. The vaporizer according to Claim 1, further comprises a cooling means to cooling down said CVD material feed portion.

12. The vaporizer according to Claim 1, wherein said CVD material is obtained by dissolving solid CVD materials into an organic solvent.
